Europäisches Patentamt

European Patent Office

Office européen des brevets

(19)

(11) Publication number: **0 260 514 B1**

# EUROPEAN PATENT SPECIFICATION

(45) Date of publication of patent specification: **19.06.91**    (51) Int. Cl.⁵: **C23C 18/16**

(21) Application number: **87112662.9**

(22) Date of filing: **31.08.87**

(54) **Photoselective metal deposition process.**

(30) Priority: **15.09.86 US 907280**

(43) Date of publication of application:
**23.03.88 Bulletin 88/12**

(45) Publication of the grant of the patent:
**19.06.91 Bulletin 91/25**

(84) Designated Contracting States:
**DE FR GB IT NL**

(56) References cited:
**EP-A- 0 180 101**
**EP-A- 0 182 193**

(73) Proprietor: **GENERAL ELECTRIC COMPANY**
**1 River Road**
**Schenectady New York 10022(US)**

(72) Inventor: **Cole, Herbert Stanley, Jr.**
**10 Sandalwood Lane**
**Scotia New York 12302(US)**
Inventor: **Liu, Yung Sheng**
**101 Woodhaven Drive**
**Scotia New York 12302(US)**
Inventor: **Sitnik, Theresa Ann**
**232 Third Street**
**Scotia New York 12302(US)**
Inventor: **Levinson, Lionel Monty**
**1 Linda Lane**
**Schenectady New York 12309(US)**

(74) Representative: **Catherine, Alain et al**
**General Electric France Service de Propriété**
**Industrielle 18 Rue Horace Vernet**
**F-92136 Issy-Les-Moulineaux Cedex(FR)**

## Description

The present invention is directed to a process for electrolessly plating metal on a substrate by exposing at least a portion of the substrate to laser radiation and to products produced thereby. The present process provides high resolution metal plating, making it especially suited for plating non-planar surfaces.

Selective electroless plating of metals has long been known for the fabrication of electronic components such as printed circuit boards and semiconductor devices. The most common technique involves sensitizing the surface of the substrate (e.g., with stannous chloride) followed by activation with a palladium catalyst such as palladium chloride prior to electroless deposition. A summary of photoselective deposition methods are disclosed in Plating, August, 1970, pp. 803-806 "Selective Electroless Plating Techniques: A Survey", N. Feldstein and Plating, August, 1971, pp. 103-121 "Photoselective Metal Deposition", D.J. Sharp.

In order to carry out selective plating, patterns of catalytic nuclei must be provided on the substrate surface, which typically involves masking portions of the surface to differentiate areas to be plated from areas which are not to be plated. Such masking operations are carried out on essentially flat surfaces using materials such as photoresists, inks and the like. However, with recent developments in the fabrication of printed circuit boards and semiconductor devices it is now desirable to plate non-planar surfaces. Currently, it is exceedingly difficult to plate raised and rounded surfaces using conventional technology which employs planar masks.

Masks are also disadvantageous because a new mask must be made every time there is a change in the plating pattern. This makes it difficult and costly to manufacture small quantities of printed circuit devices and semiconductor devices.

Recently it has been established that lasers can be employed to ablatively photodecompose polymeric substances by breaking carbon-carbon bonds to produce exceedingly sharp cuts. See, IBM Research Highlights, "Heatless Laser Etching", November 3, 1983. Further work in this area has shown that lasers, and particularly excimer lasers, emit radiation in the ultraviolet region in which the depth of cut is dependent on several factors including the fluence ($mJ/cm^2$) applied to the surface to be cut. (J.Vac.Sci-Technol., May/June 1985, pp. 913-917; J.App.Phys. 57(4), February 15, 1985, pp. 1420-1422; and J-Vac.Sci.Technol., October-December, 1983, pp. 923-925)

Lasers of the type described above, especially excimer lasers, can be usefully employed in a process for producing electronic circuitry which eliminates the use of masks and provides sharp cuts having a width in the micron region. EP-A-O 182 193 describes a method as disclosed in the preamble of claim 1.

It is therefore an object of the invention to provide a photoselective metal deposition process in which fine lines can be plated on a substrate, even on raised and/or rounded surfaces.

It is a further object of the invention to provide a photoselective metal deposition process in which use of conventional masks is eliminated.

It is a still further object of the invention to provide a photoselective metal deposition process in which it is relatively simple to change the deposition pattern as the substrate is being plated.

It is another object of the invention to provide metal plated substrates having fine lines of metal deposited thereon, which are useful for the production of printed circuits, semiconductor devices and other electronic components.

The present invention is directed to methods of electrolessly plating a metal on a substrate comprising:

(a) coating the substrate with at least one layer of an ablatively-removable material;

(b) irradiating at least a portion of the coated layer with a sufficient amount of laser radiation to thereby ablatively remove the irradiated portions of the coated layer;

(c) coating the resulting irradiated substrate with a catalyst capable of instigating the electroless deposition of the metal to be plated when contacted by an electroless plating solution; and characterized by:

(d) contacting the catalyst-coated substrate with an electroless plating solution to plate the metal on the irradiated portion of the substrate and simultaneously remove the unirradiated catalyst-coated layer.

The present invention is also directed to products produced by the above-described methods which are useful as electronic components including printed circuit boards, semiconductor devices and the like.

The features of the invention believed to be novel are set forth with particularity in the appended claims. The invention itself, however, both as to organization and method of operation, together with further objects and advantages thereof, may best be understood by reference to the following description taken in conjunction with the accompanying drawings in which:

Figures 1(a)-1(d) are diagrammatic, sectional views showing sequential steps of one embodiment of the invention wherein metal is deposited on an insulative material covering the substrate;

Figures 2(a)-2(d) are diagrammatic, sectional views showing sequential steps of another embodiment of the invention wherein metal is deposited directly on the substrate;

Figures 3(a)-3(d) are diagrammatic, sectional views showing sequential steps of another embodiment of the invention wherein an organic soluble layer is interposed between the insulative layer on the substrate and a water-soluble polymer layer; and

Figures 4(a)-4(d) are diagrammatic, sectional views showing sequential steps of another embodiment of the invention wherein a water-soluble layer is interposed between the insulative layer and a topmost layer of an organic soluble material.

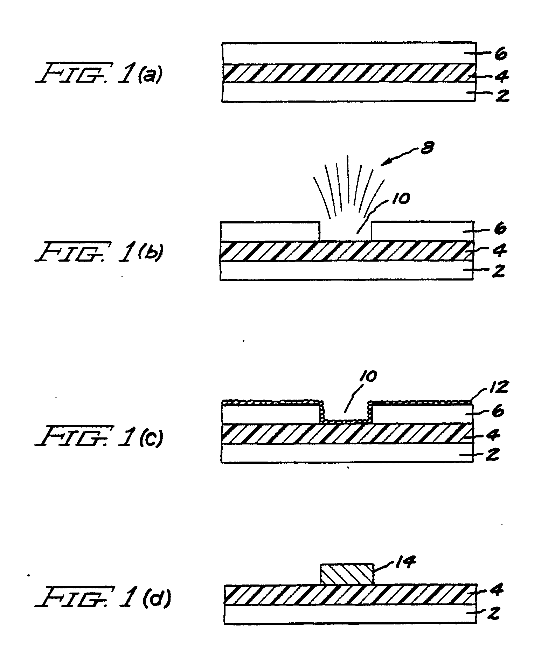

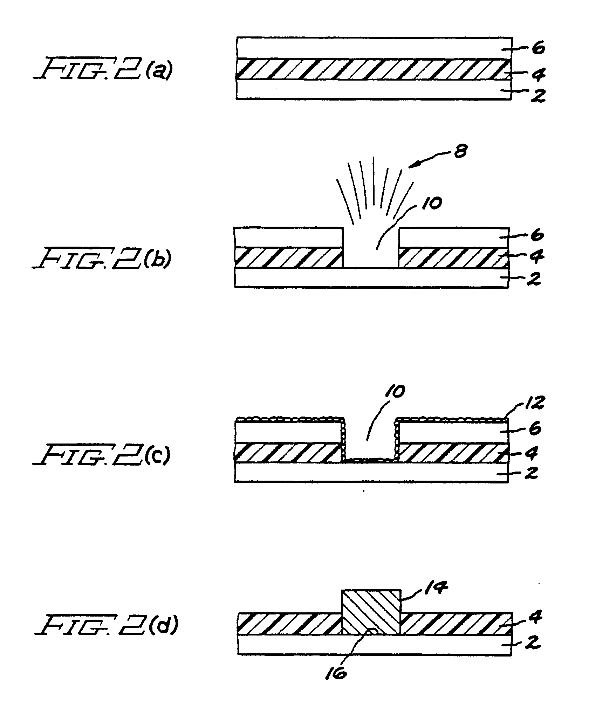

The present invention comprises a method of electrolessly plating a metal on a substrate. As shown in Figures 1(a)-1(d), substrate 2 is generally any substrate suitable for receiving thereon an electrolessly plated metal coating, or which can have thereon an insulative layer which can receive the metal coating. It is preferred that the substrate comprise a dielectric and/or microcircuit material. Suitable substrates include one or more of ceramics, polyimides, alumina, silicone-polyimides, silicon, silicone rubbers, silicon dioxide and the like. The substrate may also have thereon a metal pad which can be adapted to provide an interconnection between, for example, printed circuit patterns.

As shown in Figure 1(a), substrate 2 may be, optionally, coated with a layer of insulative material 4 when an interconnection between printed circuit patterns is not desired. Such insulative materials are known in the art and include, for example, insulative plastics such a polyimides, polysulfones, silicone polyimides, epoxies and Mylar®. A water-soluble layer 6 is coated on insulative layer 4 and preferably comprises a water-soluble polymer. Suitable water-soluble polymers include polyvinylpyrrolidone, polyvinyl alcohol, gelatin and polyalkylene ethers. Polyvinyl pyrrolidone is particularly preferred. The water-soluble layer is coated at a thickness sufficient to insure complete coverage of the substrate preferably from (500Å to 3000Å) 0.05$\mu$m to 0.3$\mu$m.

Referring to Figure 1(b), the portion of the substrate to be plated is irradiated, as shown by reference numeral 8, with radiation from an excimer laser (not shown) such as one employing a noble gas/halide gas mixture (e.g., argon-fluorine gas mixture) to break apart the carbon-carbon bonds of the water-soluble polymer to thereby ablatively remove water-soluble polymer layer 6 and form a metal deposition target area 10.

The excimer laser, e.g. a Lambda Physik excimer laser, is operated in the ultraviolet region, preferably at a wavelength of about 193nm, 248nm or 308nm at a fluence (energy level) in the range of at least about 20mJ/cm$^2$ preferably 20mJ/cm$^2$ to 300mJ/cm$^2$.

After ablation, the remaining unirradiated water-soluble polymer layer 6 and target area 10 are coated with a catalyst 12 capable of instigating the plating of metal contained in the electroless plating solution, as shown in Figure 1(c). The catalyst is preferably selected from compounds containing palladium, nickel or platinum. Palladium-containing compounds are particularly preferred. Examples of palladium-containing compounds include bis benzonitrile palladium chloride, palladium acetate, palladium bromide, palladium chloride, palladium iodide, palladium nitrate, palladium 1,1,1,5,5,5,-hexafluoro-2,4-pentanedionate, palladium 2,4-pentanedionate, palladium trifluoroacetate and elemental palladium. Elemental palladium may be applied to the ablated substrate by conventional techniques such as evaporation and chemical sputtering.

The amount of the catalyst used to cover the substrate must be sufficient to instigate the deposition of a uniform layer of metal in those areas where deposition is required.

The substrate, thus activated by catalyst 12, is then contacted with the electroless plating solution to deposit a layer of metal 14 in activated target area 10. At the same time, the unirradiated remaining portion of water-soluble polymer layer 6 having catalyst 12 thereon is rinsed away in the plating solution. As a result, the metallized substrate shown in Figure 1(d) is produced.

Virtually any metal may be plated in accordance with the present invention. Preferred metals include copper, palladium, nickel, cobalt and iron. Copper is especially preferred for electronic applications because of its excellent conductive properties. Furthermore, the metal may be plated to any thickness by employing well-known plating baths or by first forming a layer of metal in accordance with the invention and then plating thereover by conventional plating techniques.

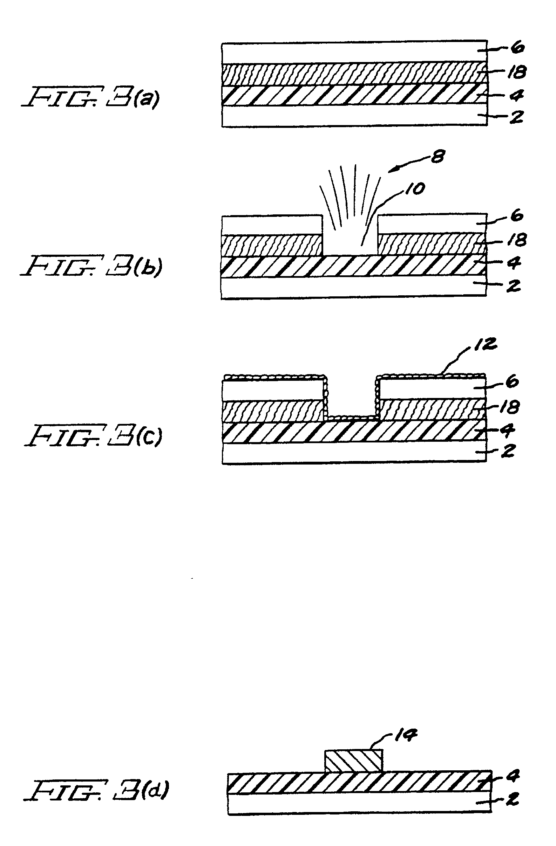

In another embodiment of the invention as shown in Figures 2(a)-2(d), both water-soluble polymer layer 6 and insulative layer 4 are ablatively removed, as indicated by reference numeral 8 (see Figure 2(b)). The remaining structure is then activated with catalyst, as indicated in Figure 2(c), and treated with the electroless plating solution to thereby form in target area 10 a metal layer 14, as shown in Figure 2(d) and, at the same time, to remove the unirradiated portion of catalyst-coated water-soluble polymer layer 6. The embodiment shown in Figures 2(a)-2(d) is especially suited for forming a conductive interconnection between printed circuit units. In this event, surface 16 of substrate 2 is provided with a metal pad embedded in the substrate. The metal pad may be made from such conductive metals as aluminum, chromium, molybdenum and the like.

In still another embodiment of the invention an organic soluble layer is positioned between the insulative material and the water-soluble polymer to provide additional protection against unwanted plating in the unirradiated regions.

Referring to Figures 3(a)-3(d), an organic soluble layer 18 such as polyvinylacetate, polystyrene, or polymethylmethacrylate is coated over insulative layer 4, dried and then coated with water-soluble polymer 6. Insulative layer 4 is thus coated with a dual layer. Ablation by an excimer laser is performed as described previously to ablate the desired portion of water-soluble polymer layer 6 and a corresponding portion of organic soluble layer 18, as shown in Figure 3(b). A layer of catalyst 12 is then applied to the substrate as shown in Figure 3-(c).

The activated substrate is immersed in a plating bath to thereby simultaneously remove the unablated portions of water-soluble layer 6 and organic soluble layer 18, while plating the metal in target area 10, as shown in figure 3(d).

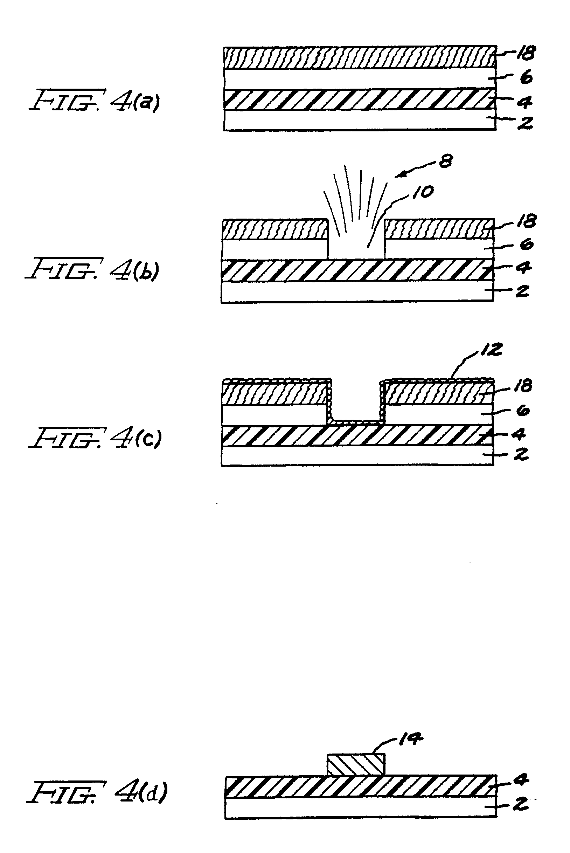

The position of water-soluble layer 6 and organic soluble layer 18 in the dual layer coated on insulative layer 4 may be reversed, and the process according to the present invention conducted as shown in Figures 4(a)-4(d). More specifically, both organic soluble layer 18 and water-soluble layer 6 are ablated, as indicated in Figure 4(b), and activated, as indicated in Figure 4(c).

Removal of unablated portions of organic soluble layer 18 and water-soluble layer 6 occurs simultaneously by immersing the activated substrate in the plating solution, resulting in the structure shown in Figure 4 (d).

The following examples are for illustrative purposes only and are not meant to limit the invention as encompassed by the claims appended hereto.

Example 1

A commercially available polyimide (Pyralin 2540,® DuPont Chemical) was spin coated on a (2" x 2") 5.08cm x 5.08cm quartz slide. The sample was baked for 1 hour at 120°C and for an additional 30 minutes at about 250°C until the polyimide was cured. A 2% by weight solution of polyvinylpyrrolidone (Aldrich Chemical) in methanol was prepared and spin coated on the surface of the polyimide layer and then dried. The polyvinylpyrrolidone coated sample was then baked for 5 minutes at 100°C to remove trace amounts of solvent. The thickness of the resulting polyvinylpyrrolidone layer was (1,000Å) 0.1μm.

The sample was then exposed to a Lambda Physik excimer laser operating at 193nm with a 12ns pulse duration. A series of small spots and a line were written into the water-soluble layer at an energy fluence of 20mJ/cm². The spots were given from 1 to 10 pulses. The line was written by moving the sample manually and irradiating at a rate of 5 pulses per second. As a result of exposure, the polyvinylpyrrolidone layer was removed from the irradiated area. The sample was then dipped in a 1% by weight solution of bis benzonitrile palladium chloride in toluene for 5 minutes. The activated substrate was blown dry and then immersed in an electroless copper bath (sold by Enthone Corporation under the name Enplate® CU-402) at room temperature for 2 minutes. The sample was then removed from the bath and rinsed in water. The area of the sample which had been exposed to the excimer laser coated a bright film of copper. The unirradiated regions did not have a metallized layer thereon because the water-soluble protective coating washed off in the plating bath.

Example 2

A sample was prepared in an identical manner as in Example 1. The sample was then exposed to the Lambda Physik excimer laser operating at 248nm with a 12ns pulse. The sample was irradiated through a metal line mask at an energy fluence of about 100 mJ/cm². After exposure, the sample was activated with evaporated palladium and electrolessly plated as described in Example 1. Fine lines of copper appeared in the irradiated regions. Copper plating did not take place in the unirradiated regions.

Example 3

A microscope slide was coated with polyvinylpyrrolidone to a thickness of (1000 Å) 0.1 μm from a 2% by weight solution in methanol. The sample was irradiated as described in Example 2. Thereafter, the sample was dipped in palladium acetate, dried and then immersed in an electroless copper bath (Metex® 9620) available from MacDermid, Incorporated, for 2 minutes at 60°C. The irradiated regions plated a bright copper and the unirradiated regions were void of copper.

**Claims**

1. A method of electrolessly plating a metal on a substrate comprising:
   (a) coating the substrate with at least one layer of an ablatively-removable material to form a coated substrate;
   (b) irradiating at least a portion of the coated substrate with a sufficient amount of laser radiation to thereby ablatively remove the irradiated portion of the layer coated on the substrate;

(c) coating the resulting irradiated substrate with a catalyst capable of instigating electroless deposition of the metal to be plated when contacted by an electroless plating solution; and characterized by:

(d) contacting the catalyst-coated substrate with an electroless plating solution to thereby plate the metal on the catalyst-coated irradiated portion of the substrate and simultaneously remove the unirradiated portion of the catalyst-coated layer.

2. The method of claim 1 wherein the electrolessly plated metal is selected from the group consisting of copper, palladium, nickel, cobalt and iron.

3. The method claim 2 wherein the electrolessly plated metal comprises copper.

4. The method of claim 1 wherein the catalyst is selected from the group consisting of palladium-containing compounds, nickel-containing compounds and platinum-containing compounds.

5. The method of claim 1 wherein said catalyst is selected from the group consisting of bis benzonitrile palladium chloride, palladium acetate, palladium bromide, palladium chloride, palladium iodide, palladium nitrate, palladium 1,1,1,5,5,5-hexafluoro-2,4-pentanedionate, palladium 2,4-pentanedionate, palladium trifluoroacetate and elemental palladium.

6. The method of claim 1 wherein the ablatively-removable material comprises a water-soluble polymer.

7. The method of claim 6 wherein the water-soluble polymer is selected from the group consisting of polyvinylpyrrolidone, polyvinyl alcohol, gelatin and polyalkylene ethers.

8. The method of claim 6 wherein the water-soluble polymer comprises polyvinylpyrrolidone.

9. The method of claim 1 wherein step (b) further comprises irradiating at least a portion of the coated substrate with laser radiation in the far to near ultraviolet region at a fluence of at least about 20 mJ/cm$^2$

10. The method of claim 9 wherein the rate of fluence is from about 20 mJ/cm$^2$ to about 300 mJ/cm$^2$.

11. The method of claim 9 wherein the laser comprises an excimer laser.

12. The method of claim 9 wherein the wavelength of the laser radiation is selected from the group of wavelengths consisting of 193nm, 248nm and 308nm.

13. The method of claim 1 wherein the substrate comprises one of the group consisting of polyimides, alumina, ceramics, silicone-polyimides, polysulfones, silicon, silicone rubbers and silicon dioxide.

14. The method of claim 1 wherein the substrate includes a metal layer in the irradiated portion of the substrate, the plated metal being deposited on the metal layer to thereby provide a means of electrically interconnecting the substrate and another electronic component.

15. The method of claim 1 wherein the substrate includes a layer of insulative material thereon and the layer of ablatively-removable material is coated on the insulative layer.

16. The method of claim 15 wherein step (b) comprises irradiating at least a portion of the ablatively-removable layer and the corresponding portion of the insulative layer in registry therewith, with said laser radiation to thereby ablatively remove the irradiated portion of the coated, ablatively-removable layer and corresponding irradiated portion of the insulative layer.

17. The method of claim 1 wherein the substrate is non-planar.

18. The method of claim 1 wherein the at least one layer of ablatively-removable material includes an organic soluble layer.

19. The method of claim 18 wherein the organic soluble layer comprises one of the group consisting of polyvinylacetate, polystyrene and polymethylmethacrylate.

20. The method of claim 18 wherein the substrate includes a layer of insulative material thereon and the at least one layer of ablatively-removable material is coated on the layer of insulative material.

**Revendications**

1. Procédé de dépôt non électrolytique d'un métal sur un substrat comprenant les étapes suivantes :

(a) revêtir le substrat d'au moins une couche d'un matériau pouvant être enlevé pour former un substrat revêtu ;

(b) irradier au moins une partie du substrat revêtu par une quantité suffisante de rayonnement laser pour enlever ainsi la partie irradiée de la couche déposée sur le substrat ;

(c) revêtir le substrat irradié résultant d'un catalyseur pouvant provoquer le dépôt non électrolytique du métal à déposer quand il est mis en contact avec une solution de revêtement non électrolytique ; et caractérisé par :

(d) mettre le substrat revêtu de catalyseur au contact d'une solution de revêtement électrolytique pour déposer ainsi le métal sur la partie irradiée revêtue de catalyseur du substrat et enlever simultanément la partie non irradiée de la couche revêtue de catalyseur.

2. Procédé selon la revendication 1, dans lequel le métal déposé par voie non électrolytique est choisi dans le groupe comprenant le cuivre, le palladium, le nickel, le cobalt et le fer.

3. Procédé selon la revendication 2, dans lequel le métal déposé par voie non électrolytique comprend du cuivre.

4. Procédé selon la revendication 1, dans lequel le catalyseur est choisi dans le groupe comprenant des composés contenant du palladium, des composés contenant du nickel et des composés contenant du platine.

5. Procédé selon la revendication 1, dans lequel le catalyseur est choisi dans le groupe comprenant du dibenzonitrile chlorure de palladium, de l'acétate de palladium, du bromure de palladium, du chlorure de palladium, de l'iodure de palladium, du nitrate de palladium, de l'hexafluoro 1,1,1,5,5,5 pentanedionate 2,4 de palladium, du pentanedionate 2,4 de palladium, du trifluoroacétate de palladium et du palladium élémentaire.

6. Procédé selon la revendication 1, dans lequel le matériau enlevable comprend un polymère soluble dans l'eau.

7. Procédé selon la revendication 6, dans lequel le polymère soluble dans l'eau est choisi dans le groupe comprenant la polyvinylpyrrolidone, l'alcool de polyvinyle, la gélatine et des éthers de polyalkylène.

8. Procédé selon la revendication 6, dans lequel le polymère soluble dans l'eau comprend de la polyvinylpyrrolidone.

9. Procédé selon la revendication 1, dans lequel l'étape (b) comprend en outre l'étape consistant à irradier au moins une partie du substrat revêtu par un rayonnement laser dans la région du lointain au proche ultraviolet à une énergie par unité de surface d'au moins 20mJ/cm$^2$.

10. Procédé selon la revendication 9, dans lequel l'énergie par unité de surface va d'environ 20 mJ/cm$^2$ à environ 300 mJ/cm$^2$.

11. Procédé selon la revendication 9, dans lequel le laser comprend un laser à excimère.

12. Procédé selon la revendication 9, dans lequel la longueur d'onde du rayonnement laser est choisi dans le groupe de longueurs d'onde comprenant 193 nm, 248 nm et 308 nm.

13. Procédé selon la revendication 1, dans lequel le substrat comprend un matériau du groupe comprenant les polyimides, l'alumine, les céramiques, les polyimides au silicone, les polysulfones, le silicium, les caoutchoucs au silicone et le dioxyde de silicium.

14. Procédé selon la revendication 1, dans lequel le substrat comprend une couche métallique dans la partie irradiée du substrat, le métal déposé l'étant sur la couche métallique pour fournir ainsi un moyen d'interconnecter électriquement le substrat et un autre composant électronique.

15. Procédé selon la revendication 1, dans lequel le substrat comprend une couche du matériau isolant sur sa face supérieure et la couche de matériau enlevable est déposée sur la couche isolante.

16. Procédé selon la revendication 15, dans lequel l'étape (b) comprend une irradiation d'au moins une partie de la couche enlevable et de la partie correspondante de la couche isolante alignée avec celle-ci, au moyen d'un rayonnement laser pour enlever ainsi la partie irradiée de la couche enlevable déposée et de la partie irradiée correspondante de la couche isolante.

17. Procédé selon la revendication 1, dans lequel le substrat est non plan.

18. Procédé selon la revendication 1, dans lequel ladite au moins une couche de matériau enlevable comprend une couche organique soluble.

19. Procédé selon la revendication 18, dans lequel la couche organique soluble comprend un produit du groupe comprenant le polyimideacétate, le polystyrène et le polyméthylméthacrylate.

20. Procédé selon la revendication 18, dans lequel le substrat comprend une couche de matériau isolant et ladite au moins une couche de matériau enlevable est déposée sur la couche de matériau isolant.

## Ansprüche

1. Verfahren zum stromlosen Plattieren eines Metalles auf einem Substrat, umfassend:
   (a) Überziehen des Substrates mit mindestens einer Schicht eines entfernbaren Materials zur Bildung eines überzogenen Substrates;
   (b) Bestrahlen mindestens eines Teiles der überzogenen Substrates mit genügend Laserstrahlung, um den bestrahlten Teil der auf das Substrat aufgebrachten Schicht durch Verdampfen zu entfernen;
   (c) Überziehen des erhaltenen bestrahlten Substrates mit einem Katalysator, der die stromlose Abscheidung des aufzubringenden Metalles anregt, wenn er mit einer Lösung zum stromlosen Plattieren in Berührung gebracht wird, gekennzeichnet durch
   (d) das Inberührungbringen des mit Katalysator überzogenen Substrates mit einer stromlosen Platierungslösung, um dadurch das Metall auf dem mit Katalysator überzogenen bestrahlten Teil des Substrates abzuscheiden und gleichzeitig den nicht bestrahlten Teil der mit Katalysator überzogenen Schicht zu entfernen.

2. Verfahren nach Anspruch 1, worin das stromlos abgeschiedene Metall ausgewählt ist aus der Gruppe bestehend aus Kupfer, Palladium, Nickel, Kobalt und Eisen.

3. Verfahren nach Anspruch 2, worin das stromlos abgeschiedene Metall Kupfer umfaßt.

4. Verfahren nach Anspruch 1, worin der Katalysator ausgewählt ist aus der Gruppe bestehend aus palladium-, nickel- und platinhaltigen Verbindungen.

5. Verfahren nach Anspruch 1, worin der Katalysator ausgewählt ist aus der Gruppe bestehend aus Bisbenzonitril-palladiumchlorid, Palladiumazetat, Palladiumbromid, Palladiumchlorid, Palladiumiodid, Palladiumnitrat, Palladium-1,1,1,5,5,5-hexafluoro-2,4-pentandionat, Palladium-2,4-pentandionat, Palladiumtrifluoroazetat und elementares Palladium.

6. Verfahren nach Anspruch 1, worin das entfernbare Material ein wasserlösliches Polymer umfaßt.

7. Verfahren nach Anspruch 6, worin das wasserlösliche Polymer ausgewählt ist aus der Gruppe bestehend aus Polyvinylpyrrolidon, Polyvinylalkohol, Gelatine und Polyalkylenäther.

8. Verfahren nach Anspruch 6, worin das wasserlösliche Polymer Polyvinylpyrrolidon umfaßt.

9. Verfahren nach Anspruch 1, worin Stufe (b) weiter das Bestrahlen mindestens eines Teiles des überzogenen Substrates mit Laserstrahlung im fernen bis nahen UV-Bereich einer Stärke von mindestens etwa 20 mJ/cm$^2$ umfaßt.

10. Verfahren nach Anspruch 9, worin die Strahlungsstärke im Bereich von etwa 20 mJ/cm$^2$ bis etwa 300 mJ/cm$^2$ liegt.

11. Verfahren nach Anspruch 9, worin der Laser einen Excimerlaser umfaßt.

12. Verfahren nach Anspruch 9, worin die Wellenlänge der Laserstrahlung ausgewählt ist aus der Gruppe von Wellenlängen bestehend aus 193 nm, 248 nm und 308 nm.

13. Verfahren nach Anspruch 1, worin das Substrat eines aus der Gruppe bestehend aus Polyimiden, Aluminiumoxid, Keramiken, Silikon-Polyimiden, Polysulfonen, Silizium, Silikonkautschuken und Siliziumdioxid umfaßt.

14. Verfahren nach Anspruch 1, worin das Substrat eine Metallschicht im bestrahlten Teil umfaßt, das abgeschiedene Metall auf der Metallschicht aufgebracht wird, um dadurch eine Einrichtung zum elektrischen Verbinden des Substrates und einer anderen elektronischen Komponente zu schaffen.

15. Verfahren nach Anspruch 1, worin das Substrat eine Schicht isolierenden Materials darauf einschließt und die Schicht aus entfernbarem Material auf der isolierenden Schicht abgeschieden wird.

16. Verfahren nach Anspruch 15, worin Stufe (b) das Bestrahlen mindestens eines Teiles der entfernbaren Schicht und des entsprechenden Teiles der isolierenden Schicht in Ausrichtung damit mit der Laserstrahlung umfaßt, um dadurch den bestrahlten Teil der aufgebrachten, entfernbaren Schicht und den entsprechenden bestrahlten Teil der isolierenden Schicht zu entfernen.

17. Verfahren nach Anspruch 1, worin das Substrat nicht planar ist.

18. Verfahren nach Anspruch 1, worin die mindestens eine Schicht aus entfernbarem Material eine organische lösliche Schicht einschließt.

19. Verfahren nach Anspruch 18, worin die organische lösliche Schicht eines der Gruppe bestehend aus Polyvinylazetat, Polystyrol und Polymethylacrylat umfaßt.

20. Verfahren nach Anspruch 18, worin das Substrat eine Schicht isolierenden Materials darauf einschließt und die mindestens eine Schicht aus entfernbarem Material auf der Schicht aus isolierendem Material aufgebracht ist.

FIG. 1(a)

FIG. 1(b)

FIG. 1(c)

FIG. 1(d)

FIG. 2 (a)

FIG. 2 (b)

FIG. 2 (c)

FIG. 2 (d)

*FIG. 3(a)*

*FIG. 3(b)*

*FIG. 3(c)*

*FIG. 3(d)*

*FIG.* 4(a)

*FIG.* 4(b)

*FIG.* 4(c)

*FIG.* 4(d)